# EUROPÄISCHE PATENTANMELDUNG

(11) **EP 0 649 024 A1**
(43) Veröffentlichungstag der Anmeldung: **19.04.1995**
(21) Anmeldenummer: 94115529.3
(22) Anmeldetag: 01.10.1994
(51) Int. Cl.: G01R 11/24

(54) **Statischer Elektrizitätszähler**

(30) Priorität: 15.10.1993 CH 3127/93
(71) Anmelder: ZELLWEGER LUWA AG, CH-8610 Uster (CH)
(72) Erfinder: Mayer, Christian, CH-8630 Tann (CH); Widmer, René, CH-8610 Uster (CH)
(74) Vertreter: Ellenberger, Maurice

(57) **Zusammenfassung**

Der Zähler ist in einem Gehäuse eingebaut, welches einen durch eine Plombe gesicherten Gehäusedeckel (3) und einen ebenfalls plombierten Klemmendeckel aufweist. Der Gehäusedeckel (3) enthält einen Schlitz zur Aufnahme eines Schiebers (12, 14, 15) mit einem Beschriftungsfeld (8), auf dem Zählereinstellungen angegeben sind. Der Schieber ragt mit einem Ende (15) aus dem Schlitz. Dieses Ende ist vom Klemmendeckel abgedeckt, so dass der Schieber (12, 14, 15) gegen unbefugten Zugriff gesichert ist.

## Beschreibung

Die vorliegende Erfindung betrifft einen statischen Elektrizitätszähler mit einem Gehäuse mit einem durch eine Plombe gesicherten Gehäusedeckel und einem ebenfalls plombierten Klemmendeckel, und mit einem am Gehäusedeckel angeordneten Beschriftungsfeld zur sichtbaren Darstellung von Zählereinstellungen.

Elektrizitätszähler dieser Art weisen eine von aussen zugängliche Schnittstelle auf, über die Parametrierungen oder Einstellungen des Zählers vorgenommen werden können, ohne dass der Gehäusedeckel geöffnet werden muss. Beispiele solcher Einstellungen sind unter anderem die Zuweisung von Rundsteuerbefehlen zu verschiedenen Zählerregistern, Angaben über Funktionstests und Angaben über die Funktion von im Gehäuse gegebenenfalls integrierten Lastrelais zur Schaltung von bestimmten Lasten, wie beispielsweise von Warmwasserboilern.

Diese Einstellungen können über die Schnittstelle rasch und einfach verändert werden, was immer auch entsprechende Änderungen im Beschriftungsfeld bedingt. Und das bedeutet in der Regel eine Auswechslung des Beschriftungsfeldes. Andererseits ist aber darauf zu achten, dass das Beschriftungsfeld nicht durch unbefugte Personen ausgewechselt werden kann, was bei einem bekannten Zähler der eingangs genannten Art durch einen den Gehäusedeckel übergreifenden, plombierten Überdeckel verhindert wird.

Durch die Erfindung soll nun ein Elektrizitätszähler angegeben werden, dessen Beschriftungsfeld einfach auswechselbar und trotzdem gegen unbefugte Manipulationen gesichert ist, und zwar mit möglichst geringem Aufwand, insbesondere ohne Überdeckel und ohne zusätzliche Plombe.

Diese Aufgabe wird erfindungsgemäss dadurch gelöst, dass das Beschriftungsfeld auf einem plattenartigen, unter oder in den Gehäusedeckel einschiebbaren und gegen unbefugtes Herausnehmen gesicherten, Träger vorgesehen ist.

Im folgenden wird die Erfindung anhand eines Ausführungsbeispiels und der Zeichnungen näher erläutert; es zeigen:
- Fig. 1: eine perspektivische Darstellung eines Elektrizitätszählers,
- Fig. 2: eine Vorderansicht des Gehäusedeckels des Zählers von Fig. 1,
- Fig. 3: ein Detail von Fig. 2; und
- Fig. 4: eine ausschnittsweise Ansicht in Richtung des Pfeiles IV von Fig. 2.

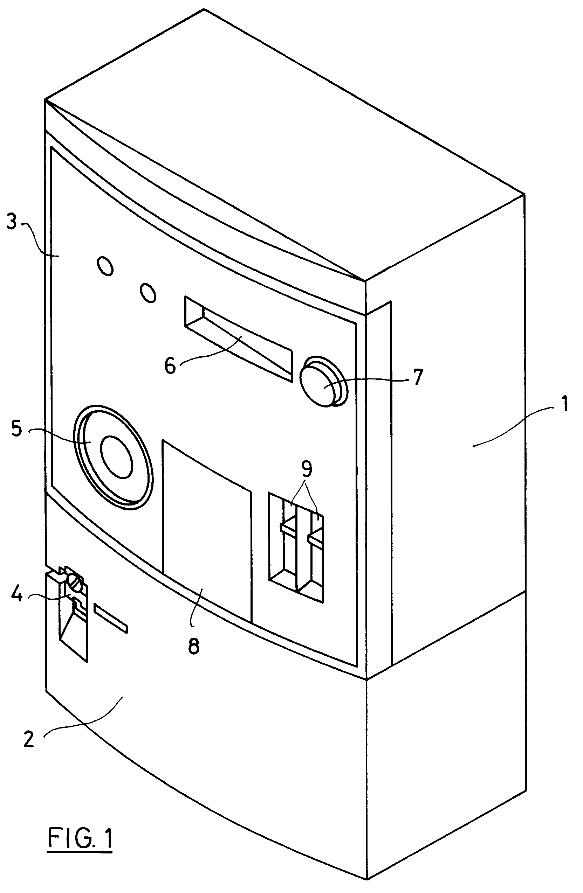

Das in Fig. 1 dargestellte Zählergehäuse besteht im wesentlichen aus einem schachtelartigen Gehäuseboden 1, der in seinem unteren Teil von einem Klemmendeckel 2 und in seinem oberen Teil durch einen Gehäusedeckel 3 abgedeckt ist. Der Klemmendeckel 2 ist durch eine Klemmendeckelplombe 4 gegen unberechtigtes Öffnen gesichert. Wird diese Plombe gebrochen, dann kann der Klemmendeckel 2 geöffnet werden, womit einerseits der Zugang zu den Zählerklemmen und andererseits zu einer den Gehäusedeckel 3 gegen unberechtigtes Öffnen sichernden Gehäusedeckelplombe freigelegt ist.

Wie Fig. 1 weiter zu entnehmen ist, ist am Gehäusedeckel 3 eine optische Schnittstelle 5 für den Zugriff zu einem inneren Datenspeicher des Zählers vorgesehen. Diese Schnittstelle dient zur Parametrierung des Zählers, für die Eingabe von Einstelldaten, zur Programmierung und zur Übertragung des Zählerstandes zur externen Ablesung. Der Zugriff zum inneren Datenspeicher über die Schnittstelle 5 ist nur nach Eingabe eines Passwortes möglich. Ausserdem weist der Gehäusedeckel 1 ein numerisches Anzeigefeld 6, einen Knopf 7 für den Abruf der im Anzeigefeld 6 anzuzeigenden Daten und ein Beschriftungsfeld 8 mit den verschiedenen Einstellungen auf. Beispiele für solche Einstellungen sind die Zuweisungen von Rundsteuerbefehlen zu verschiedenen Zählerregistern.

Diese Zählerregister sind mehrere Tarifregister, die dem im Gehäuse angeordneten Messelement für die verbrauchte elektrische Energie beliebig zugeordnet werden können. Die Tarifschaltung erfolgt vorzugsweise über ein im Gehäuse eingebautes Rundsteuer-Modul, welches ausserdem mit dem Bezugszeichen 9 bezeichnete, optionale, integrierte Lastrelais für die direkte Schaltung von Warmwasserboiler oder anderen Lasten steuern kann.

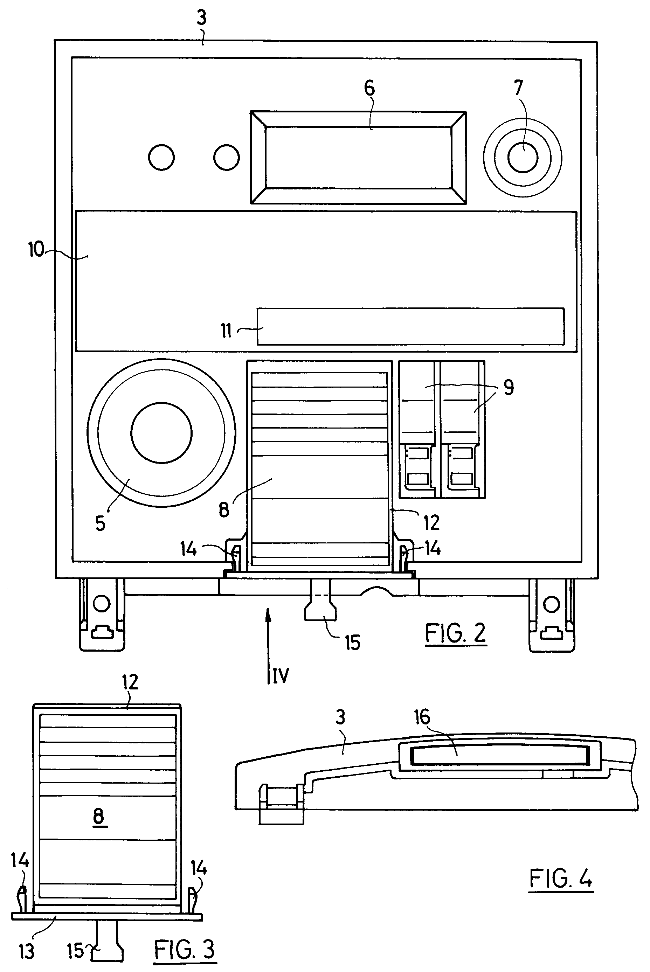

Wie Fig. 2 zu entnehmen ist, ist der Gehäusedeckel 3 in vertikaler Richtung in drei Bereiche unterteilt, die die folgenden Betätigungs-/Anzeigeelemente und Informationsfelder enthalten: Im obersten Feld befinden sich das numerische Anzeigefeld 6 und der Knopf 7 sowie das oder die Warenzeichen des Herstellers, beispielsweise die Aufschriften "z zellweger" und "z'enerwatt". Das mittlere Feld 10 ist ein reines Informationsfeld mit Angaben über Hersteller, Typenbezeichnung, Seriennummer sowie über technische Details, und mit einem individuellen maschinenlesbaren Code 11 für jeden Zähler. Das untere Feld enthält einerseits die Schnittstelle 5 und gegebenenfalls ein oder zwei Lastrelais 9 sowie das Beschriftungsfeld 8 mit Angaben über Zählereinstellungen. Da diese Einstellungen über die Schnittstelle 5 geändert werden können, sind die Angaben im Beschriftungsfeld 8 nicht unveränderlich, sondern müssen gegebenenfalls an geänderte Einstellungen angepasst werden.

Eine einfache Änderung der Angaben im Beschriftungsfeld 8 wird dadurch ermöglicht, dass dieses auf einem plattenartigen Träger 12 angeordnet ist. Vorzugsweise wird das Beschriftungsfeld 8 als Etikette gedruckt und dann auf den Träger aufgeklebt.

Wie Fig. 3 zu entnehmen ist, ist der Träger 12 von einem Steg 13 getragen, der einen bundartigen Abschluss der unteren Kante des Trägers 12 bildet. Auf dem Steg 13 sind zu beiden Seiten neben dem Träger 12 zwei federnde Schnappelemente 14 angeordnet, die zur Fixierung des Trägers 12 im Gehäusedeckel 3 dienen. An der vom Träger 12 abgewandten Seite des Stegs 13 ist ein Betätigungsgriff 15 vorgesehen. Der Träger 12, der Steg 13 und der Betätigungsgriff 15 bilden zusammen einen Schieber, der vorzugsweise einstückig aus Kunststoff hergestellt ist.

Gemäss Fig. 4 weist der Gehäusedeckel 3 in seiner die genannten Informationsfelder und Elemente tragenden Vorderwand einen schlitzartigen Hohlraum 16 auf, der zum Einschieben des Trägers 12 vorgesehen ist; bei voll eingeschobenem Träger 12 ist der Hohlraum 16 nach unten durch den Steg 13 abgedeckt. An der Eintrittsöffnung des Hohlraums 16 ist links und rechts ein zum Einrasten des jeweiligen Schnappelements 14 vorgesehener Vorsprung vorgesehen.

Wie Fig. 2 zu entnehmen ist, ragt bei voll in den Gehäusedeckel 3 eingeschobenem Schieber nur dessen Betätigungsgriff 15 aus dem Gehäusedeckel 3. In Fig. 1 ist der Betätigungsgriff 15 nicht zu sehen, weil er durch den Klemmendeckel 2 abgedeckt ist. Da der Klemmendeckel 2 durch die Plombe 4 gesichert ist, bedeutet dies, dass durch diese Plombe auch der Schieber mit dem Beschriftungsfeld 11 gegen unbefugte Manipulation gesichert ist. Da die den Klemmendeckel 2 sichernde Plombe 4 ohnehin vorhanden ist, bietet die gleichzeitige Plombierung von Klemmendeckel 2 und Schieber mit Beschriftungsfeld 11 eine Sicherung des letzteren ohne zusätzlichen Aufwand.

Selbstverständlich braucht das Beschriftungsfeld 8 nicht unbedingt auf einen Schieber der beschriebenen Art aufgeklebt zu werden. Es ist auch möglich, ein einfaches Karton- oder Papierschild in einen entsprechenden schmäleren Hohlraum 16 einzuschieben und dort mit geeigneten Mitteln zu fixieren. Auch ein derartiges Schild stellt einen plattenartigen Träger dar. Wesentlich ist, dass dieser Träger einfach auswechselbar und dass er gegen unbefugten Zugriff gesichert ist.

## Patentansprüche

1. Statischer Elektrizitätszähler mit einem Gehäuse und mit einem durch eine Plombe gesicherten Gehäusedeckel und einem ebenfalls plombierten Klemmendeckel, und mit einem am Gehäusedeckel angeordneten Beschriftungsfeld zur sichtbaren Darstellung von Zählereinstellungen, dadurch gekennzeichnet, dass das Beschriftungsfeld (8) auf einem plattenartigen, unter oder in den Gehäusedeckel (3) einschiebbaren und gegen unbefugtes Herausnehmen gesicherten, Träger (12) vorgesehen ist.

2. Elektrizitätszähler nach Anspruch 1, dadurch gekennzeichnet, dass der Träger (12) an einen mit einem Betätigungsgriff (15) versehenen Steg (13) angearbeitet ist und mit diesem einen Schieber bildet.

3. Elektrizitätszähler nach Anspruch 2, dadurch gekennzeichnet, dass auf dem Schieber (12, 13, 15) elastische Haltemittel zur Fixierung des Schiebers in einer Halterung angeordnet sind.

4. Elektrizitätszähler nach Anspruch 3, dadurch gekennzeichnet, dass die Haltemittel durch auf dem Steg (13) zu beiden Seiten des Trägers (12) angeordnete Schnapporgane (14) gebildet sind.

5. Elektrizitätszähler nach einem der Ansprüche 2 bis 4, dadurch gekennzeichnet, dass der Schieber (12-15) einstückig aus Kunststoff gefertigt, und dass das Beschriftungsfeld (8) als Klebetikette ausgebildet ist.

6. Elektrizitätszähler nach Anspruch 3, dadurch gekennzeichnet, dass die Halterung durch einen im Gehäusedeckel (3) vorgesehenen Schlitz (16) zum Einschieben des Schiebers (12-15) gebildet ist.

7. Elektrizitätszähler nach den Ansprüchen 4 und 6, dadurch gekennzeichnet, dass an der Eintrittsöffnung des Schlitzes (16) nasenartige Vorsprünge zum Einrasten der Schnapporgane (14) angeordnet sind.

8. Elektrizitätszähler nach Anspruch 1, dadurch gekennzeichnet, dass der Träger 12 so ausgebildet ist, dass er mit einem Ende den Gehäusedeckel (3) überragt, und dass dieses Ende vom Klemmendeckel (2) überdeckt ist.

9. Elektrizitätszähler nach den Ansprüchen 2 und 8, dadurch gekennzeichnet, dass das genannte Ende des Trägers (12) durch den Betätigungsgriff (15) gebildet ist.
